# EUROPÄISCHE PATENTANMELDUNG

(11) **EP 2 680 015 A2**
(43) Veröffentlichungstag der Anmeldung: **01.01.2014**
(21) Anmeldenummer: 13171847.0
(22) Anmeldetag: 13.06.2013
(51) Int. Cl.: G01R 22/10, G01R 21/133

(54) **Ermittlung eines Energieverbrauchs in einem Haushaltsgerät**

(30) Priorität: 26.06.2012 DE 102012210849
(71) Anmelder: BSH Bosch und Siemens Hausgeräte GmbH, 81739 München (DE)
(72) Erfinder: Maier, Thomas, 84518 Garching a.d. Alz (DE); Marbach, Andreas, 83374 Traunwalchen (DE); Röber, Christoph, 89269 Vöhringen (DE)

(57) **Zusammenfassung**

Es werden eine Schaltung und ein Verfahren zur Ermittlung eines Energieverbrauchs in einem Haushaltsgerät vorgeschlagen, mit einem Sensor (101; 204) anhand dessen eine Strominformation und eine Spannungsinformation detektierbar sind und mit einer Verarbeitungseinheit (102; 209), die mit dem Sensor (101; 204) gekoppelt ist und anhand derer der Energieverbrauch des Haushaltsgeräts ermittelbar ist. Weiterhin wird ein entsprechendes Haushaltsgerät mit einer solchen Schaltung angegeben.

## Beschreibung

Die Erfindung betrifft eine Schaltung sowie ein Verfahren zur Ermittlung eines Energieverbrauchs in einem Haushaltsgerät. Weiterhin wird ein Haushaltsgerät vorgeschlagen mit einer solchen Schaltung.

Grundsätzlich besteht die Anforderung, eine Leistungs- und Verbrauchsmessung in Haushaltsgeräten zu ermöglichen. Hierfür können sowohl Strom als auch Spannung gemessen werden, da die Netzspannung bestimmten Toleranzen unterliegt. Aus den gemessenen Werten kann auf die Leistung (Produkt aus Strom und Spannung) bzw. die verbrauchte elektrische Energie rückgeschlossen werden.

Hierbei besteht zugleich die Aufgabe, trotz der Messungen die Stromaufnahme in einem Ruhebetrieb (Standby-Modus) des Haushaltsgeräts nicht wesentlich zu erhöhen. Mit anderen Worten soll die Messung nicht die Ursache für einen hohen Energieverbrauch des Haushaltsgeräts sein. Insbesondere sollen vorgegebene Grenzwerte für den Energieverbrauch im Standby-Modus eingehalten werden.

Die **Aufgabe** der Erfindung besteht darin, eine effiziente Möglichkeit zur Messung eines Energieverbrauchs eines Haushaltsgeräts anzugeben, wobei Strom- und Spannungsmessungen insbesondere mittels eines einzigen Sensors durchgeführt werden.

Diese Aufgabe wird gemäß den Merkmalen der unabhängigen Patentansprüche gelöst. Weiterbildungen der Erfindung ergeben sich auch aus den abhängigen Ansprüchen.

Zur Lösung der Aufgabe wird eine Schaltung angegeben zur Ermittlung eines Energieverbrauchs in einem Haushaltsgerät,
- mit einem Sensor anhand dessen eine Strominformation und eine Spannungsinformation detektierbar sind und
- mit einer Verarbeitungseinheit, die mit dem Sensor gekoppelt ist und anhand derer der Energieverbrauch des Haushaltsgeräts ermittelbar ist.

Somit wird es möglich anhand eines einzelnen Sensors sowohl Spannungs- als auch Strominformation zu erfassen und hieraus den Energieverbrauch, z.B. die elektrische Leistung, zu bestimmen.

Ein Haushaltsgerät kann sowohl ein Haushaltsgroßgerät (Gargerät, Wäschebehandlungsgerät, Kühlgerät, usw.) als auch ein Haushaltskleingerät (Kaffeemaschine, Toaster, usw.) sein.

Eine Weiterbildung ist es, dass der Sensor ein Magnetfeldsensor oder ein magnetoresistiver Sensor ist.

Eine andere Weiterbildung ist es, dass der Sensor einer einen der folgenden Sensoren umfasst:
- einen Hall-Sensor,
- einen AMR-Sensor,
- einen GMR-Sensor.

Insbesondere ist es eine Weiterbildung, dass der Sensor induktiv mit einer Leiterbahn gekoppelt ist, wobei die Leiterbahn mit einer Last verbunden ist und diese mit einem Wechselstrom speist.

Der Wechselstrom bedingt ein sich änderndes Magnetfeld, dass mittels des Sensors detektierbar ist. Damit kann der Sensor eine Strominformation liefern, die zum Betrieb des Verbrauchers bzw. der Last oder des Haushaltsgeräts maßgeblich ist.

Auch ist es eine Weiterbildung, dass der Sensor induktiv mit mindestens einer Leitung oder mindestens einer Leiterbahn gekoppelt ist, die über einen Widerstand einen Gleichstrom führt, der proportional zu einer Versorgungsspannung ist.

Hieraus folgt ein Gleichanteil eines Stroms, der proportional zu der Versorgungsspannung ist. Dieser Gleichanteil des Stroms kann ebenfalls durch den Sensor detektiert werden und liefert ein Maß für die Versorgungsspannung.

Ferner ist es eine Weiterbildung, dass die mindestens eine Leitung oder mindestens eine Leiterbahn eine im Wesentlichen spiralförmig angeordnete Leiterbahn umfasst, wobei der Sensor in der Nähe derjenigen (nahezu parallelen oder konzentrischen) Leiterbahnen der spiralförmigen Leiterbahn angeordnet ist, die den Strom in die gleiche Richtung führen.

Im Rahmen einer zusätzlichen Weiterbildung entspricht die Versorgungsspannung einer gleichgerichteten Netzspannung zum Betrieb des Haushaltsgeräts.

Eine nächste Weiterbildung besteht darin, dass die Verarbeitung ein Mikroprozessor und/oder einen Mikrocontroller umfasst, der über eine einzelne Leitung die von dem Sensor detektierte Strominformation und Spannungsinformation erhält.

Somit reicht ein Anschluss oder Port des Mikroprozessors oder Mikrocontrollers aus, um das kombinierte Signal des Sensors zu erfassen, zu digitalisieren und auszuwerten.

Eine Ausgestaltung ist es, dass der Sensor einer Strommessbrücke entspricht, wobei die Brückenspannung an die zwei Eingänge eines Messverstärkers anlegbar ist und der Ausgang des Messverstärkers mit der Verarbeitungseinheit verbunden ist.

Eine alternative Ausführungsform besteht darin, dass die Ermittlung des Energieverbrauchs kontinuierlich, quasi-kontinuierlich oder zu vorgegebenen Zeiten oder mit einer vorgegebenen Rate durchführbar ist.

Eine nächste Ausgestaltung ist es, dass die Strominformation und die Spannungsinformation in einem zeitlichen Multiplexbetrieb detektierbar sind.

So können z.B. die Strominformation und die Spannungsinformation zu unterschiedlichen Zeiten bestimmt werden.

Auch ist es eine Ausgestaltung, dass die Verarbeitungseinheit zumindest zeitweise mit einer zentralen Einheit, insbesondere mit einem Smart Grid und/oder einer Gebäude-Überwachung, verbindbar ist.

Eine Weiterbildung besteht darin, dass anhand der Verarbeitungseinheit ein ungünstiger Zustand detektierbar ist.

Insbesondere kann der ungünstige Zustand, z.B. eine unzulässige Spannungsschwankung z.B. akustisch und/oder optisch signalisiert werden. Alternativ oder zusätzlich kann eine Nachricht an eine vorgegebene Adresse oder Einheit, z.B. ein Gebäudemanagement, z.B. über das Internet, versendet werden.

Die vorstehend genannte Aufgabe wird auch gelöst durch ein Haushaltsgerät umfassend eine Schaltung wie hierin beschrieben.

Weiterhin wird die obige Aufgabe gelöst mittels eines Verfahrens zur Ermittlung eines Energieverbrauchs in einem Haushaltsgerät,
- bei dem mittels eines einzelnen Sensors eine Strominformation und eine Spannungsinformation detektiert werden und
- bei dem mittels einer Verarbeitungseinheit, die mit dem Sensor gekoppelt ist, der Energieverbrauch des Haushaltsgeräts ermittelt wird.

Hierbei sei angemerkt, dass die obigen Merkmale ebenso für dieses Verfahren anwendbar sind.

Ausführungsbeispiele der Erfindung werden nachfolgend anhand der Zeichnungen dargestellt und erläutert.

Es zeigen:
- Fig.1: eine beispielhafte Anordnung zur Messung eines Stroms und einer Spannung mit einem einzelnen Sensor;
- Fig.2: eine alternative Ausführungsform zur Messung des Energieverbrauchs mittels eines Sensors, der als eine Messbrücke dargestellt ist.

Es wird vorgeschlagen, einen Energieverbrauch, insbesondere eine elektrische Leistung eines Haushaltsgeräts zu bestimmen, indem ein Strom sowie eine Spannung des Haushaltsgeräts erfasst bzw. gemessen werden. Hierbei werden Strom und Spannung bzw. daraus abgeleitete Größen mit einem einzigen Sensor bestimmt.

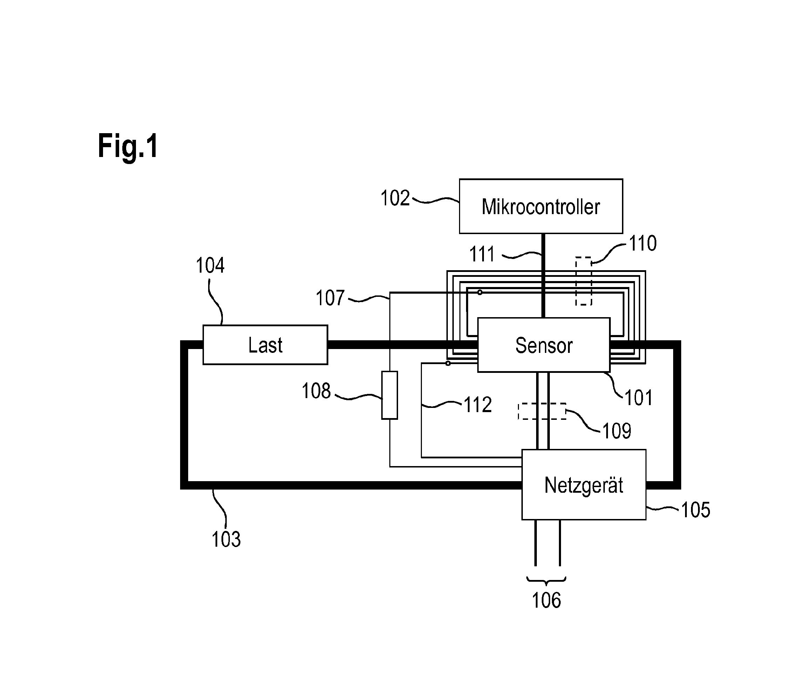

Ein Messwert des Stromes liegt als eine Wechselgröße und ein der Versorgungsspannung proportionaler, Spannungs- bzw. Stromwert liegt als eine Gleichgröße vor. Ein sich ergebendes kombiniertes Signal (z.B. Summensignal) umfasst sowohl die Spannungs- als auch die Strominformation. Mittelwert und Amplitude des kombinierten Signals können anhand eines Mikrocontrollers bestimmt werden. Beispielsweise können elektrische Größen über integrierte Analog/DigitalWandler des Mikrocontrollers erfasst werden. Der Mikrocontroller kann basierend auf den erfassten digitalen Werten die Leistung bzw. die elektrischen Arbeit bestimmen. **Fig.1** zeigt eine beispielhafte Anordnung zur Messung eines Stroms und einer Spannung mit einem einzelnen Sensor 101.

Eine Versorgungsspannung oder Netzspannung 106 (z.B. 230V AC, 50Hz) wird an ein Netzgerät 105 angelegt. Das Netzgerät 105 stellt eine Versorgungspannung 109 für den Sensor 101 bereit. Weiterhin ist das Netzgerät 105 mit einer Leiterbahn 103 (z.B. auf der Unterseite einer Leiterplatte) verbunden, über die ein Strom z.B. in einem Bereich von 1A bis 16A bei 230V und 50Hz einer Last 104 bereitgestellt wird. Bei der Last 104 kann es sich z.B. um einen Motor, eine Heizung, o.ä. des Haushaltsgeräts handeln.

Der Sensor 101 ist vorzugsweise als ein Magnetfeldsensor ausgeführt, der den durch die Leiterbahn 103 fließenden Strom anhand des durch ihn hervorgerufenen magnetischen Wechselfelds erkennen bzw. messen kann. Beispielsweise kann es sich bei dem Sensor 101 um einen Hall-Sensor handeln.

Zusätzlich sind eine Vielzahl von spiralförmigen Windungen 110 auf der Leiterplatte in der Nähe der Leiterbahn 103 angeordnet, wobei der Sensor einen Teil der Windungen 110 (die vorzugsweise im Wesentlichen parallel zueinander angeordnet sind und einen in die gleiche Richtung fließenden Strom aufweisen) sowie die Leiterbahn 103 überdeckt bzw. mit diesen magnetisch gekoppelt ist.

Die spiralförmigen Windungen sind über eine Leitung 112 und über eine Leitung 107 mit einem Widerstand 108 (zur Strombegrenzung) mit dem Netzgerät 105 verbunden.

Ein Mikrocontroller 102 ist über eine Signalleitung 111 mit dem Sensor 101 gekoppelt. Der Mikrokontroller 102 kann somit das von dem Sensor 101 gelieferte (kombinierte) Spannungssignal erfassen und auswerten.

Somit wird der Sensor 101 neben einem zu messenden Strom durch die Last 104 (der als eine Wechselgröße vorliegt) auch mit einem der Netzspannung 106 proportionalem Strom (der als eine Gleichgröße vorliegt und über die Leitungen 107 und 112 bereitgestellt wird) beaufschlagt. Der (Magnetfeld-)Sensor 101 liefert somit eine Spannung, die einer Kombination aus den beiden Stromsignalen durch die Leitung 103 sowie die Windungen 110 entspricht.

Über den Widerstand 108 ist es möglich, einen Gleichstrom zu erzeugen, der sich proportional zur Ausgangsspannung des Netzgeräts 105 verhält. Es gibt verschiedene Möglichkeiten, den Gleichstrom zu generieren; beispielsweise wird die Gleichspannung durch einen Gleichrichter, z.B. eine Diode und einen Kondensator (nicht in Fig.1 dargestellt), bereitgestellt. Das durch diesen Gleichstrom verursachte elektrische Feld in den Windungen 110 bewirkt einen Gleichspannungsanteil an dem Ausgang des Sensors 101. Darüber hinaus erfasst der Sensor 101 das elektromagnetische Wechselfeld des Lastkreises (Last 104, die über die Leiterbahn 103 mit dem Netzgerät 105 verbunden ist).

Über die Signalleitung 111 kann der Mikrocontroller eine Signalauswertung durchführen, wobei der Wechselanteil des Signals dem Strom durch die Leiterbahn 103 und der Gleichanteil der Messung der Versorgungsspannung 106 entspricht.

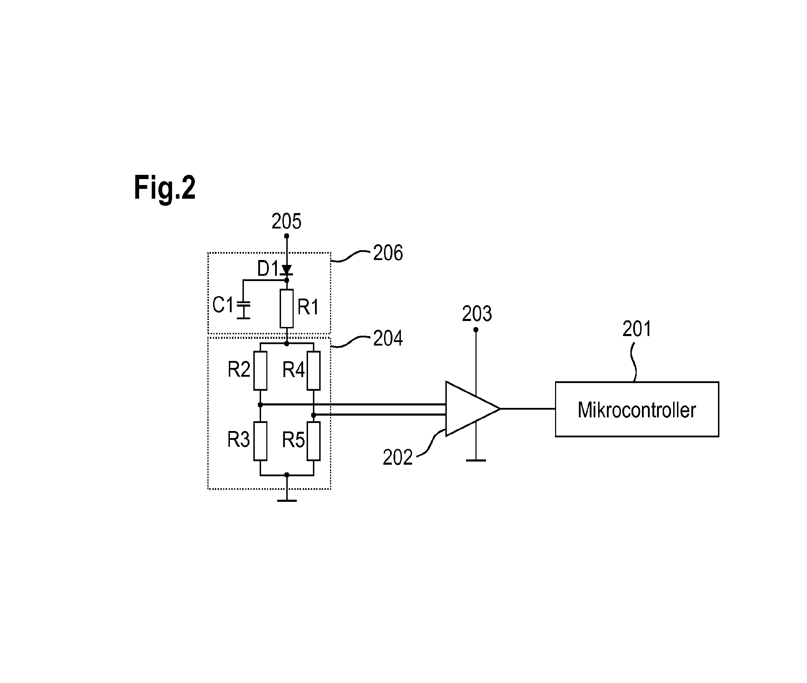

**Fig.2** zeigt eine alternative Ausführungsform zur Messung des Energieverbrauchs mittels eines Sensors 204, der als eine Messbrücke dargestellt ist.

Eine Netzspannung 205 wird über einen Gleichrichter 206 gleichgerichtet und dem Sensor 204 (der als Stromsensor geschaltet ist) zugeführt. Der Gleichrichter 206 umfasst eine Diode D1, einen Kondensator C1 sowie einen Widerstand R1, wobei die Anode der Diode D1 mit der Netzspannung 205 und die Kathode der Diode D1 über den Widerstand R1 mit dem Sensor verbunden ist. Der Kondensator C1 ist liegt zwischen der Kathode der Diode D1 und Massepotential. Der Stromsensor 204 umfasst eine erste Serienschaltung aus einem Widerstand R2 und einem Widerstand R3 und eine zweite Serienschaltung aus einem Widerstand R4 und einem Widerstand R5, wobei die erste und die zweite Serienschaltung parallel geschaltet sind. Der gemeinsame Knoten der Widerstände R2 und R4 ist mit dem Gleichrichter 206 und der gemeinsame Knoten der Widerstände R3 und R5 ist mit Massepotential verbunden.

Der Mittenabgriff zwischen den Widerständen R2 und R3 ist mit einem ersten Eingang eines Messverstärkers 202 und der Mittenabgriff zwischen den Widerständen R4 und R5 ist mit einem zweiten Eingang des Messverstärkers 202 verbunden. Der Messverstärker 202 ist mit einer Versorgungsspannung 203 und mit dem Massepotential verbunden. Der Ausgang des Messverstärkers 202 ist mit einem Mikrocontroller 201 verbunden.

Der als Messbrücke ausgebildete Sensor 204 wird mit einer gleichgerichteten Spannung basierend auf der Netzspannung oder Versorgungsspannung 205 versorgt, die proportional zu der zu messenden Spannung ist.

Eine Möglichkeit besteht darin, die in einem (nicht in Fig.2 dargestellten) Netzgerät bereits vorhandene, gleichgerichtete jedoch noch nicht stabilisierte Netzspannung abzugreifen. Diese gleichgerichtete Netzspannung entspricht einer Gleichkomponente an den Eingängen des Messverstärkers. Überlagert wird diese Gleichkomponente von einer laststromabhängigen Wechselgröße. Die an dem Sensor 204 abgegriffene Brückenspannung zwischen den Mittenabgriffen der in Reihe geschalteten Widerstände entspricht der Summe der beiden Signale, d.h. der Gleichkomponente und der laststromabhängigen Wechselgröße. Der Messverstärker 202 wird vorzugsweise an der stabilisierten Spannung 203 betrieben. Die weitere Signalverarbeitung erfolgt in dem Mikrocontroller 201: der Wechselanteil basiert auf dem Strom in der Leiterbahn und der Gleichanteil basiert auf der Versorgungsspannung.

Bei dem hier verwendeten Sensor kann es sich z.B. um einen Magnetfeldsensor, einen magnetoresistiven Sensor, einen Hall-Sensor, um einen AMR-Sensor oder um einen GMR-Sensor handeln.

Um den Energieverbrauch im Standby-Betrieb zu optimieren, kann zumindest eine der folgenden Maßnahmen eingesetzt werden:
(a) Der Abgriff für die Spannungsmessung erfolgt nach einem Hauptschalter des Haushaltsgeräts.
(b) Falls die Spannung an dem Netzanschluss gemessen wird, kann die elektrische Versorgung durch elektromechanische bzw. elektronische Bauteile während des Standby-Betriebs abgeschaltet werden.
(c) Eine zeitkontinuierliche Messung der Spannung ist nicht erforderlich: So kann eine gelegentliche Messung des Energieverbrauchs ausreichend sein und so ein unnötiger Strombedarf vermieden werden.

Beispielsweise kann eine Spannungsmessung gemäß einem vorgegebenen Zeitintervall, z.B. alle 10 Sekunden, durchgeführt werden. So kann die Spannung über die Messung einer Sekundärspannung des Netzgeräts (das z.B. als ein Schaltnetzteil ausgeführt ist) erfolgen. Der Übertrager (Transformator) des Netzgeräts wird hierfür geeignet mittels einer Pulsweitenmodulation angesteuert: Der Lastkreis kann für kurze Zeit unterbrochen werden, so dass die Versorgung der Steuerung aus der gespeicherten Energie der in dem Netzgerät vorhandenen Kondensatoren erfolgen kann. Zeitgleich wir die Regelschleife des Netzgeräts unterbrochen. Nun kann der zur Primär- bzw. Zwischenkreisspannung proportionale Wert als Sekundärspannung abgegriffen werden. Dieses Signal ist bereits galvanisch getrennt.

### Weitere Ausgestaltungen und Vorteile:

Ein Vorteil der vorliegenden Lösung ist es, dass z.B. mittels des galvanisch getrennt arbeitenden Sensors die Spannungsmessung galvanisch getrennt erfolgt. Die galvanische Trennung ist in vielen Haushaltsgeräten erforderlich, da eine durchgängige Schutzisolierung nicht möglich ist. Der Aufwand der vorgestellten Lösung für die galvanische Trennung ist vergleichsweise gering damit entsprechend kostengünstig zu realisieren.

Ein weiterer Vorteil besteht darin, dass durch den vorgeschlagenen Sensor, der Strom- und Spannungsmessung durchführt, Bauteil- und Entwicklungskosten eingespart werden können. Auch ist weniger Bauraum erforderlich.

Zusätzlich ist es von Vorteil, dass Strominformation und Spannungsinformation in kombinierter Form über eine gemeinsame Leitung (z.B. den Ausgang des Sensors oder eines Verstärkers) übertragen werden können und so bei dem Mikrocontroller nur ein einziger Eingang erforderlich ist.

Mit einem einzigen Sensor werden Strom- und Spannungsinformation erfasst. Dieser Vorteil wirkt sich besonders günstig in zwei- oder dreiphasigen Systemen aus.

In existierenden Netzgeräten ist ein Abgriff der noch nicht stabilisierten Gleichspannung in der Regel problemlos möglich. Damit ist die hier vorgeschlagene Spannungsmessung ohne großen Aufwand in existierenden Geräten oder in Kombination mit üblichen Netzgeräten einsetzbar.

Die Leistungsmessung ermöglicht die aktuelle Anzeige des Verbrauchs und ggf. der damit verbundenen Energie-Kosten für das Haushaltsgerät. Im Hinblick auf sogenannte Smart Grid Anwendungen (intelligentes Stromnetz, siehe z.B. http://de.wikipedia.org/wiki/Smart_Grid) kann der aktuelle Energieverbrauch entsprechend geeignet ausgewertet werden.

Auch ist es ein Vorteil, dass Spannungsschwankungen besser überwacht werden können. Da ein übermäßig starker Spannungsabfall an dem Haushaltsgerät beim Einschalten einer Last (z.B. einem Motor oder einer Heizung) feststellbar wäre, könnte ein fehlerhafter Geräteanschluss beim Kunden erkannt und ggf. entsprechend signalisiert werden. Ursache für einen fehlerhaften Geräteanschluss könnte z.B. ein zu schwaches Anziehen der Anschlussschrauben oder eine mangelhafte Gebäudeinstallation sein. Der Fehler könnte dem Kunden oder über eine entsprechende Kommunikationsschnittstelle auch einem Kommunikationsteilnehmer (z.B. einer Zentrale oder einer Gebäude-Überwachung) signalisiert werden, um einer unerwünschten Erwärmung oder einer Beschädigung zuvorzukommen.

Bei Haushaltsgeräten mit ohmschen Heizkörpern (Rohrheizkörper, Strahlungsheizkörper) kann die vom Heizkörper abgegebene Energie, durch die Messung der Versorgungsspannung und die entsprechende Steuerung der "Einschaltzeit" konstant gehalten werden.

### Bezugszeichenliste

- 101: Sensor (z.B. Magnetfeldsensor)
- 102: Mikrocontroller
- 103: Leitung
- 104: Last
- 105: Netzgerät
- 106: Netzspannung
- 107: Leitung
- 108: Widerstand
- 109: Versorgungsspannung für Sensor
- 110: Windungen
- 111: Signalleitung
- 112: Leitung
- 201: Mikrocontroller
- 202: Messverstärker
- 203: Versorgungsspannung des Messverstärkers
- 204: Sensor
- 205: Netzspannung
- 206: Gleichrichter
- R1-R5: Widerstände
- D1: Diode
- C1: Kondensator

## Patentansprüche

1. Schaltung zur Ermittlung eines Energieverbrauchs in einem Haushaltsgerät,
- mit einem Sensor (101; 204) anhand dessen eine Strominformation und eine Spannungsinformation detektierbar sind und
- mit einer Verarbeitungseinheit (102; 209), die mit dem Sensor (101; 204) gekoppelt ist und anhand derer der Energieverbrauch des Haushaltsgeräts ermittelbar ist.

2. Schaltung nach Anspruch 1, bei der der Sensor ein Magnetfeldsensor oder ein magnetoresistiver Sensor ist.

3. Schaltung nach einem der vorhergehenden Ansprüche, bei der der Sensor einer einen der folgenden Sensoren umfasst:
- einen Hall-Sensor,
- einen AMR-Sensor,
- einen GMR-Sensor.

4. Schaltung nach einem der vorhergehenden Ansprüche, bei der der Sensor (101) induktiv mit einer Leiterbahn (103) gekoppelt ist, wobei die Leiterbahn (103) mit einer Last (104) verbunden ist und diese mit einem Wechselstrom speist.

5. Schaltung nach einem der vorhergehenden Ansprüche, bei der der Sensor (101) induktiv mit mindestens einer Leitung oder mindestens einer Leiterbahn (110) gekoppelt ist, die über einen Widerstand (108) einen Gleichstrom führt, der proportional zu einer Versorgungsspannung (106) ist.

6. Schaltung nach Anspruch 5, bei dem die mindestens eine Leitung oder mindestens eine Leiterbahn eine im Wesentlichen spiralförmige angeordnete Leiterbahn (110) umfasst, wobei der Sensor (101) in der Nähe derjenigen Leiterbahnen angeordnet ist, die den Strom in die gleiche Richtung führen.

7. Schaltung nach einem der Ansprüche 5 oder 6, bei der die Versorgungsspannung einer gleichgerichteten Netzspannung zum Betrieb des Haushaltsgeräts entspricht.

8. Schaltung nach einem der vorhergehenden Ansprüche, bei der die Verarbeitung ein Mikroprozessor und/oder einen Mikrocontroller (102) umfasst, der über eine einzelne Leitung (111) die von dem Sensor detektierte Strominformation und Spannungsinformation erhält.

9. Schaltung nach einem der vorhergehenden Ansprüche, bei der der Sensor (204) einer Strommessbrücke entspricht, wobei die Brückenspannung an die zwei Eingänge eines Messverstärkers (202) anlegbar ist und der Ausgang des Messverstärkers mit der Verarbeitungseinheit (201) verbunden ist.

10. Schaltung nach einem der vorhergehenden Ansprüche, bei der die Ermittlung des Energieverbrauchs kontinuierlich, quasi-kontinuierlich oder zu vorgegebenen Zeiten oder mit einer vorgegebenen Rate durchführbar ist.

11. Schaltung nach einem der vorhergehenden Ansprüche, bei der die Strominformation und die Spannungsinformation in einem zeitlichen Multiplexbetrieb detektierbar sind.

12. Schaltung nach einem der vorhergehenden Ansprüche, bei der die Verarbeitungseinheit zumindest zeitweise mit einer zentralen Einheit, insbesondere mit einem Smart Grid und/oder einer Gebäude-Überwachung, verbindbar ist.

13. Schaltung nach einem der vorhergehenden Ansprüche, bei der anhand der Verarbeitungseinheit ein ungünstiger Zustand detektierbar ist.

14. Haushaltsgerät mit einer Schaltung gemäß einem der vorhergehenden Ansprüche.

15. Verfahren zur Ermittlung eines Energieverbrauchs in einem Haushaltsgerät,
- bei dem mittels eines einzelnen Sensors eine Strominformation und eine Spannungsinformation detektiert werden und
- bei dem mittels einer Verarbeitungseinheit, die mit dem Sensor gekoppelt ist, der Energieverbrauch des Haushaltsgeräts ermittelt wird.
